# EUROPÄISCHE PATENTSCHRIFT

(11) **EP 1 969 908 B1**
(45) Veröffentlichungstag und Bekanntmachung des Hinweises auf die Patenterteilung: **08.07.2009**
(21) Anmeldenummer: 06830524.2
(22) Anmeldetag: 11.12.2006
(51) Int. Cl.: H05K 1/14, H05K 3/30, H05K 3/32, H05K 3/36

(54) **ELEKTRISCHES GERÄT MIT EINER GESCHMIERTEN FÜGESTELLE SOWIE VERFAHREN ZUR SCHMIERUNG EINER SOLCHEN FÜGESTELLE**
ELECTRIC DEVICE COMPRISING A LUBRICATED JOINT POINT AND METHOD FOR LUBRICATING SAID TYPE OF JOINT POINT
APPAREIL ELECTRIQUE COMPRENANT UN EMPLACEMENT D'ASSEMBLAGE LUBRIFIE, ET PROCEDE POUR LUBRIFIER UN TEL EMPLACEMENT D'ASSEMBLAGE

(30) Priorität: 27.12.2005 DE 102005062601
(43) Veröffentlichungstag der Anmeldung: 17.09.2008
(73) Patentinhaber: ROBERT BOSCH GMBH, 70442 Stuttgart (DE)
(72) Erfinder: OCHS, Eric, 72072 Tuebingen (DE); LUDWIG, Ronny, 72770 Reutlingen (DE); GRABMAIER, Florian, 72074 Tuebingen (DE); HENZLER, Stephan, 72810 Gomaringen (DE); STRAUB, Rainer, 72119 Ammerbuch (DE); VOEHRINGER, Christian, 72070 Tuebingen (DE); WELLNER, Patrick, 70184 Stuttgart (DE)
(86) Internationale Anmeldenummer: PCT/EP2006/069553
(87) Internationale Veröffentlichungsnummer: WO 2007/074049

(56) Entgegenhaltungen:
- FR-A1- 2 210 883
- GB-A- 1 142 160
- US-A- 5 384 435
- US-B1- 6 271 186

## Beschreibung

### Stand der Technik

Die Erfindung betrifft eine Verbesserung auf dem Gebiet der Einpresstechnik, die ein Verfahren zur mechanischen Stabilisierung eines Trägermaterials, beispielsweise einer Leiterplatte an einem Grundträger, der beispielsweise ein Gehäuse oder eine andere Leiterplatte sein kann. Dabei werden ein oder mehrere Einpressstifte (Pins) auf dem Grundträger in die dafür vorgesehenen Hülsen des Trägermaterials mechanisch eingepresst. Die Stifte werden dabei üblicherweise sowohl plastisch als auch elastisch verformt. Die elastische Verformung bewirkt beim Einpressvorgang eine Rückstellkraft, die dann das Trägermaterial und die Stifte mechanisch stabilisiert. Bei elektrisch leitfähigen Kontaktpartnern, bei denen beispielsweise metallische Stifte in eine metallische Beschichtung in Form einer Hülse eingesteckt werden, kann neben der mechanischen Stabilisierung auch eine elektrische Kontaktierung ermöglicht werden, so z.B. zur elektrischen Verschaltung von Steckerpins mit Schaltkreisen auf einer Leiterplatte. Durch die mechanische und evtl. auch thermische Belastung beim Einpressvorgang besteht die Gefahr, dass sich entweder auf der Oberfläche des Stifts oder an der Oberfläche der Hülse Partikel bilden. Diese Partikel oder "Beinahe-Partikel" lösen sich möglicherweise bereits während des Einpressens oder durch nachgelagerte Prozesse, die beispielsweise durch Erschütterungen eines solchen Geräts im Betrieb ausgelöst werden. Andere auslösende Prozesse können auch beispielsweise Temperaturbelastungen bzw. Temperaturwechselbelastungen sein oder auch der Einfluss von chemischen Prozessen, die beispielsweise durch erhöhte Luftfeuchtigkeit oder dem Angriff eines korrosiven Mediums ausgelöst werden. Solche "Beinahe-Partikel", sich erst unter dem Einfluss von nachgelagerten Prozessen lösen werden hier als potenziell lose Partikel bezeichnet.

Eine bekannte Maßnahme zur Verringerung von losen oder potenziell losen Partikeln besteht darin, die Reibung zwischen den Fügepartnern stark zu reduzieren. Hierzu werden beispielsweise Schmierstoffe bzw. Schmierhilfsstoffe verwendet. Das Schmieren selbst ist bei der Einpresstechnik eine übliche Maßnahme (siehe z.B. US-A-5 384 435). Dadurch wird in der Regel die Bildung von leicht beweglichen Partikeln beim Einpressen reduziert. Die Entstehung solcher Partikel kann aber durch die Verwendung eines solchen Schmierhilfsstoffes nicht ausgeschlossen werden. Besonders unerwünscht ist die Bildung von elektrisch leitfähigen Partikeln, wie sie eben bei der Einpresstechnik häufig entstehen. Derartige Partikel, die beispielsweise eine Größenordnung von ca. 100 µm bzw. 0,1 mm durchaus erreichen, können Kurzschlüsse auf elektrisch ungeschützten Leiterplatten zur Folge haben.

Eine andere Maßnahme zur Vermeidung von "vagabundierenden" Partikeln bzw. Spänen besteht darin, ein mit einer solchen Einpresstechnik hergestelltes Gerät zu vergießen und dadurch die Bewegungsfreiheit von sich erst später ablösenden Partikeln bzw. losen Partikeln von vorne herein zu beschränken. Diese Maßnahme ist jedoch äußerst aufwändig (Materialeinsatz) und weist auch noch weitere Nachteile auf. Hier ist ganz besonders die schlechte Kühlung der Bauteile erwähnenswert. Eine derartige Lösung zeigt die französische Offenlegungsschrift FR 2 753 044 A1.

### Offenbarung der Erfindung

Das erfindungsgemäße elektrische Gerät mit den Merkmalen des Hauptanspruchs hat den Vorteil, dass durch die Verwendung eines erstarrungsfähigen Schmierstoffs Späne bzw. potenzielle Späne gebunden bzw. fixiert werden. Diese können somit die Fügestelle bzw. deren nächste Umgebung nicht verlassen. Sie sind unbeweglich. Kurzschlüsse an anderen elektrischen Bereichen können damit durch diese fixierten Späne bzw. potenziellen Späne ausgeschlossen werden.

Durch die in den Unteransprüchen aufgeführten Maßnahmen sind vorteilhafte Weiterbildungen des elektrischen Geräts nach dem Hauptanspruch möglich. So ist vorgesehen, dass als Schmierstoff ein Stoff verwendet wird, der nicht metallisch ist. Dies führt dazu, dass der in der Fügestelle hoch belastete Schmierstoff keine metallischen Späne abgeben kann, die ggf. zu Kurzschlüssen führen könnten. Es ist vielmehr gemäß einer Weiterbildung der Erfindung vorgesehen, dass als Schmierstoff ein duroplastischer oder elastomerer Kunststoff verwendet wird, der durch inneres Vernetzen ausgehärtet ist (chemisch engmaschig oder weitmaschig vernetzter Kunststoff). Diese Stoffe haben den Vorteil, dass sie hochgradig temperaturbelastbar sind und dabei nicht ihre Form verlieren. Dies bedeutet, dass nach dem Aushärten ein gebundener Span beispielsweise nicht mehr freigegeben werden kann.

Als leicht handhabbar haben sich insbesondere Schmierstoffe ergeben, die aus mehreren Komponenten bestehen. Bevorzugt werden hierbei Zwei-Komponentenstoffe. Der Vorteil von Mehrkomponentenstoffen besteht darin, dass deren Lagerfähigkeit vor der Verarbeitung deutlich länger als die eines Ein-Komponentenstoffs ist.
Ein-Komponentenstoffe habe die Eigenschaft, bereits nach ihrer Herstellung mit der Aushärtung zu beginnen, was die Lagerfähigkeit derartiger Stoffe beeinträchtigt. Im Gegensatz dazu, können Mehrkomponentenstoffe mehr oder weniger unmittelbar vor der eigentlichen Verarbeitung gemischt werden, so dass deren Einzelkomponenten lange haltbar sind.

Ein weiterer Vorteil eines derartig ausgebildeten Schmierstoffs besteht darin, dass an einem vorzugsweise axialen Ende der Fügestelle zumindest teilweise die Fügestelle außen abgedichtet wird. Ein Angriff von zerstörenden, beispielsweise korrosiven Stoffen kann dadurch beschränkt werden. Gemäß einer weiteren Ausgestaltung der Erfindung ist vorgesehen, dass der ausgehärtete Schmierstoff zumindest einen metallischen Span bindet. Während die Verwendung eines zumindest teilweise erstarrten Schmierstoffs grundsätzlich von vorneherein den Vorteil bietet, überhaupt einen Span wirksam binden zu können, so ist der ausgehärtete Schmierstoff besonders dann von Vorteil, wenn er tatsächlich einen metallischen Span bindet.

Die Vorteile dieses teilweise erstarrten Schmierstoffs kommen ganz besonders dann zur Geltung, wenn der zumindest eine Span aus dem selben Material wie der erste Fügepartner oder aus dem selben Material wie der zweite Fügepartner besteht.

Ist der Span kohäsiv mit dem ersten oder zweiten Fügepartner verbunden, so verhindert der teilweise erstarrte Schmierstoff ein Ablösen des kohäsiv gebundenen Spans von dem ersten oder zweiten Fügepartner, so dass dieser sich nicht lösen und auch nicht auf einer elektrisch ungeschützten Anordnung herumvagabundieren und somit einen Kurzschluss auslösen kann. Der gleiche Vorteil ergibt sich dann, wenn der Span adhäsiv (das heißt durch Klebewirkung) oder gar formschlüssig, das heißt durch teilweises Umschließen des Spans durch den zumindest teilweise erstarrten Schmierstoff verbunden ist.

Gemäß einem nebengeordneten Anspruch ist ein Verfahren zum Schmieren einer Fügestelle eines elektrischen Geräts vorgesehen. Dieses Verfahren mit den Merkmalen des nebengeordneten Anspruchs hat den Vorteil, dass durch dieses einfache Verfahren ein bereits ansatzweise entstandener Span bzw. ein bereits vollständig abgelöster Span zuverlässig an Ort und Stelle gehalten wird, ohne dass früher oder später ein auf dem Grundträger bzw. einer Leiterplatte herumvagabundierender Span einen Kurzschluss erzeugt.

Eine einfache Möglichkeit, einen Stift als zweiten Fügepartner zu beschichten, besteht darin, diesen in einen Behälter zu tauchen, der den Schmierstoff zum Inhalt hat.

Eine weitere Möglichkeit, den Stift zu beschichten, besteht darin, diesen gezielt lokal mit Schmierstoff zu bespritzen bzw. zu betupfen. Dies gilt beispielsweise für den Bereich eines jeden Stifts, der unmittelbar ursächlich für die Spanbildung ist.

Gemäß einer weiteren Ausgestaltung des erfindungsgemäßen Verfahrens ist vorgesehen, dass der Schmierstoff vom Stift bzw. einem der Fügepartner nicht abtropft und somit tropffest ist. Dies hat zum Vorteil, dass eine für die vorgesehene Fügestelle mengenmäßig bestimmte Schmierstoffmenge auch tatsächlich die Fuge erreicht und so sicher ein Lösen bzw. Herumvagabundieren eines Spans ausgeschlossen wird.

Beispielsweise für den Fall, dass sich ein bestimmter Schmierstoff von seiner Bindewirkung her besonders eignet, kann beispielsweise auch ein Schmierstoff vorgesehen sein, der nicht tropffest ist. In einem solchen Fall kann es von Vorteil sein, dass die Hülse als erster Fügepartner mit Schmierstoff benetzt wird. Ein Abtropfen ist hier weniger wahrscheinlich, da ein Schmierstoffklecks bzw. -tupfer durch den Grundträger bzw. die Leiterplatte unterstützt wird.

Beispielsweise für den Fall, dass eine verhältnismäßig hohe Schmierstoffmenge erforderlich ist, die beispielsweise von einem Stift nicht sicher tropffest gehalten werden kann, kann es sich empfehlen, so beide Fügepartner vor dem Fügen mit Schmierstoff zu benetzen.

### Zeichnungen

In den Zeichnungen sind Ausführungsbeispiele eines erfindungsgemäßen elektrischen Geräts sowie ein Verfahren zum Schmieren einer Fügestelle eines elektrischen Geräts dargestellt.

### Es zeigen:

Figur 1 eine schematische Darstellung eines elektrischen Geräts mit einer Fügestelle,
Figur 2 ein zweites Ausführungsbeispiel einer Fügestelle,
Figur 3 eine Draufsicht auf ein axiales Ende der Fügestelle aus Figur 2,
Figur 4 ausschnittweise einen Längsschnitt durch eine Fügestelle nach einem weiteren Ausführungsbeispiel, bei der ein noch nicht abgelöster Span durch den ausgehärteten Schmierstoff gebunden ist,
Figur 5 ein weiteres Ausführungsbeispiel der Fügestelle,
Figur 6 ein weiteres Ausführungsbeispiel einer Fügestelle, wobei auf beiden, aneinander gegenüberliegenden Seiten einer Leiterplatte jeweils ein Span durch den Schmierstoff gebunden ist,
Figur 7 ausschnittweise eine Fügestelle, bei der ein bereits abgelöster Span ausschließlich durch den ausgehärteten Schmierstoff gebunden ist,
Figur 8 ein weiteres Ausführungsbeispiel einer Fügestelle, bei der ein Span nur durch Adhäsionskräfte mit dem Schmierstoff gebunden ist,

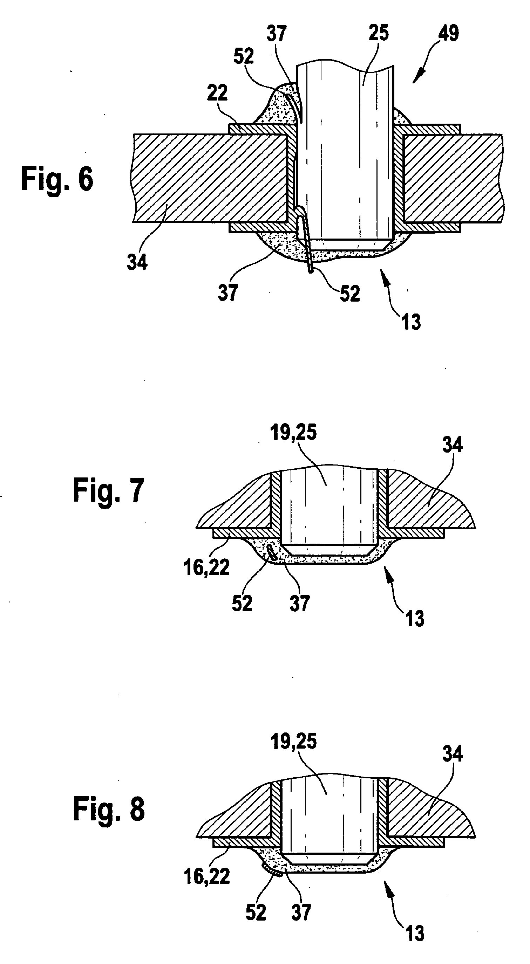

Figur 8 ein weiteres Ausführungsbeispiel der Fügestelle,

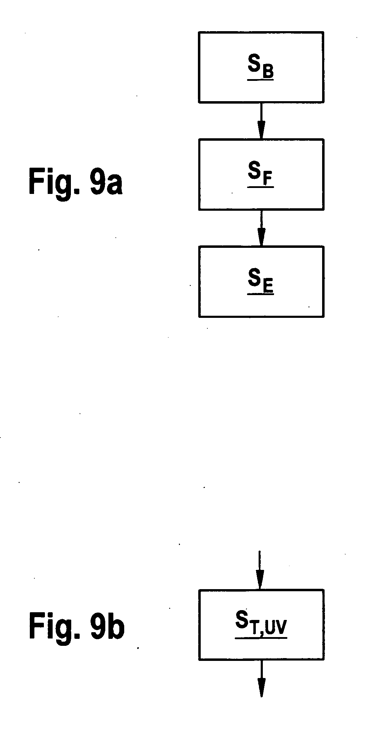

Figur 9a und 9b schematisch ein Verfahren zum Schmieren einer Fügestelle eines elektrischen Geräts,

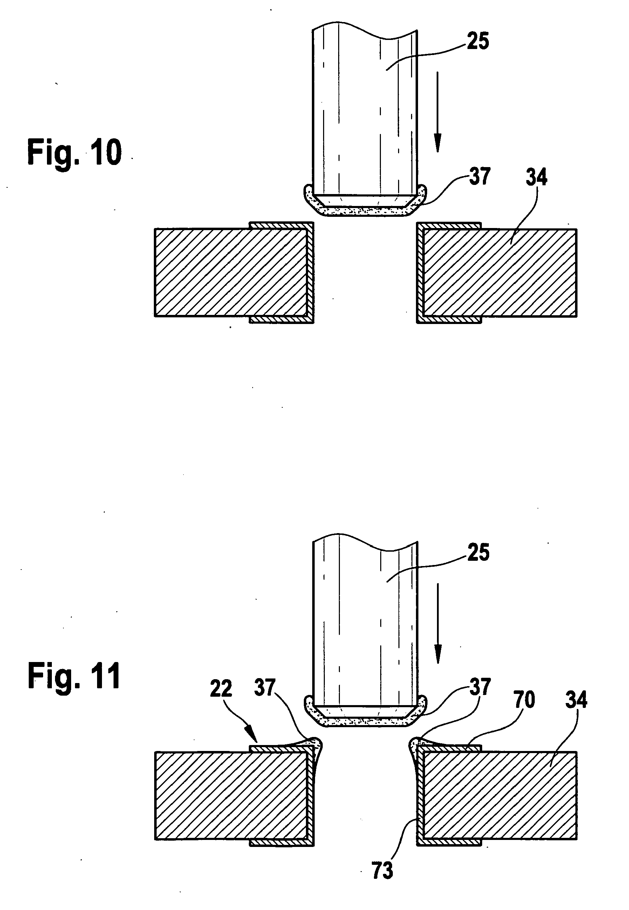

Figur 10 eine Leiterplatte und einen mit Schmierstoff benetzten Stift mit angedeuteter Fügerichtung vor dem Fügen.
Figur 11 beide Fügepartner, die mit Schmierstoff benetzt sind,

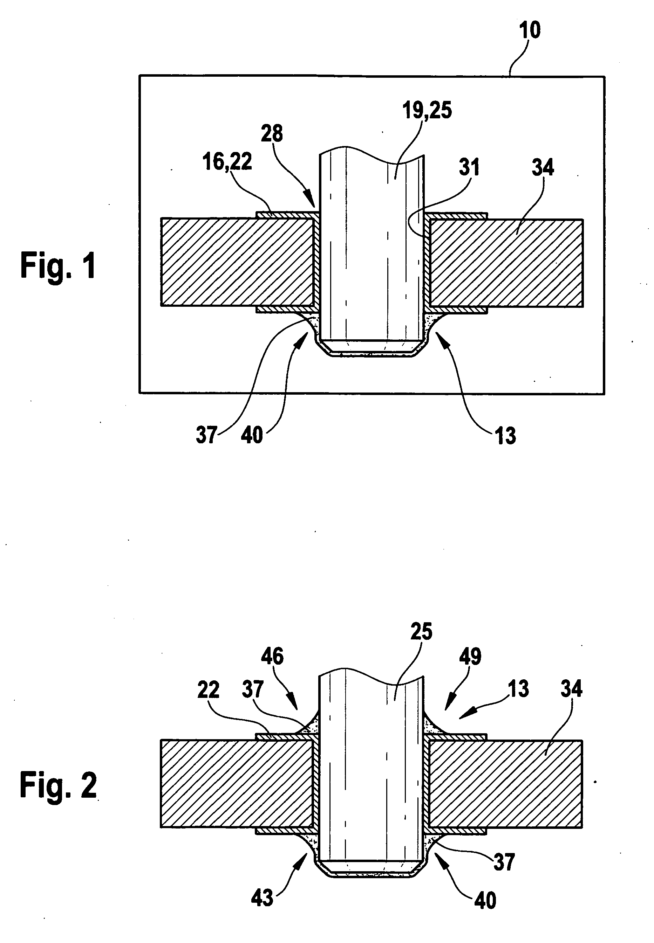

In Figur 1 ist eine schematische Darstellung eines elektrischen Geräts 10 gezeigt, das eine Fügestelle 13 aufweist. Dieses elektrische Gerät 10 kann beispielsweise ein Steuergerät oder ein Sensor o. ä. sein. Die Fügestelle 13 wird durch zwei Fügepartner 16 und 19 gebildet. Im konkreten Fall ist der Fügepartner 16 eine Hülse 22 und der zweite Fügepartner 19 ein Stift 25. Diese Fügestelle 13 kommt dadurch zu Stande, dass der zweite Fügepartner 19 in den ersten Fügepartner 16 gesteckt wird. Zwischen beiden Fügepartnern 16 und 19 ist eine Fuge 28. Die Hülse 22 stellt eine metallische Schicht dar, die eine Bohrung 31 einer Leiterplatte 34 auskleidet. Mittels dieser Hülse 22 wird ein elektrischer Kontakt zwischen dem Stift 25 und der Hülse 22 bzw. an die Hülse 22 angeschlossene weitere elektrische Kontakte und Leiterbahnen hergestellt. Ein weiteres Merkmal dieser Fügestelle 13 besteht im Schmierstoff 37, der dazu dient, einerseits die Einpresskräfte zwischen dem Stift 25 und der Hülse 22 beim Einpressen zu reduzieren (Schmierwirkung). Der Schmierstoff 37 hat darüber hinaus die Aufgabe, lose oder potenziell lose Späne bzw. Partikel, die in Figur 1 nicht dargestellt sind, zu fixieren. Dieser Schmierstoff 37 befindet sich zumindest an der Fuge 28. An der Fuge 28 bedeutet, dass der Schmierstoff 37 zumindest an einer Fugenmündung 40 und somit an einem axialen Ende der Fügestelle 13 vorhanden ist. Zumindest an der Fuge 28 kann aber auch bedeuten, dass der Schmierstoff 37 in der Fuge 28 angeordnet ist. Bezüglich des Schmierstoffs 37 ist vorgesehen, dass dieser nicht metallisch ist. Es ist ganz besonders vorgesehen, dass der Schmierstoff 37 ein duroplastischer oder elastomerer Kunststoff ist, der durch inneres Vernetzen ausgehärtet bzw. verfestigt ist. Während der Schmierstoff 37 beispielsweise auch ein Ein-Komponentenstoff sein kann, so ist doch vorzugsweise erwünscht, dass der Schmierstoff 37 ein Mehrkomponentenstoff, insbesondere ein Zwei-Komponentenstoff, ist.

Figur 2 zeigt ein zweites Ausführungsbeispiel einer Fügestelle 13, wobei im Unterschied zum Ausführungsbeispiel nach Figur 1 der Schmierstoff 37 nicht nur an der Fugenmündung 40 auf einer Seite der Leiteplatte 34 vorhanden ist, sondern auch auf einer gegenüberliegenden Seite der Leiterplatte 34 bzw. auf einer gegenüberliegenden Seite der Hülse 22. Mit anderen Worten: Die Hülse 22 weist nicht nur ein erstes axiales Ende 43 auf einer Seite einer Leiterplatte 34 auf, sondern auch noch ein zweites axiales Ende 46 auf einer der ersten Seite der Leiterplatte 34 gegenüberliegenden Seite der Leiterplatte. Auch auf dieser anderen Seite der Leiterplatte 34 weist die Fügestelle 13 eine Fugenmündung 49 auf, an der ebenfalls zumindest teilweise erstarrter Schmierstoff 37 vorhanden ist. Figur 2 zeigt übrigens eine Fügestelle 13, bei der sich kein Span durch das Fügen gebildet hat.

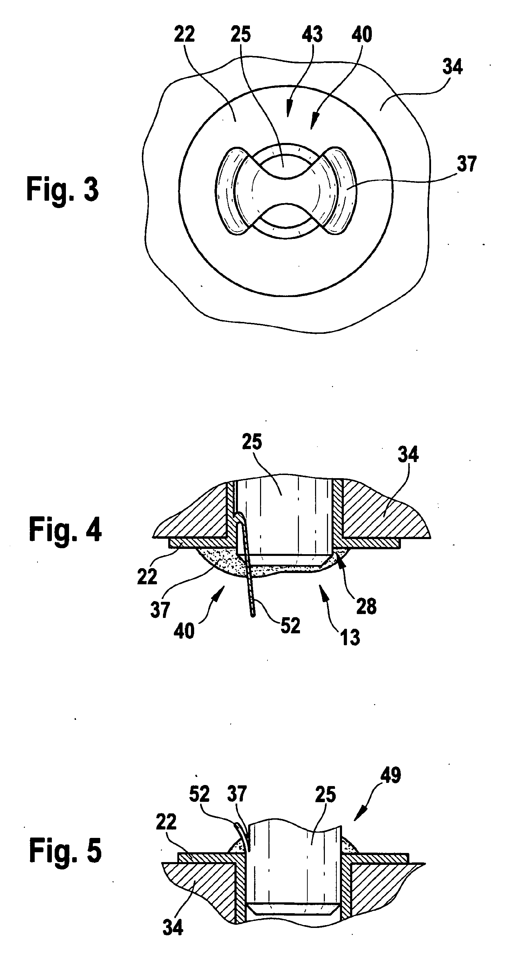

In Figur 3 ist eine Draufsicht auf das axiale Ende 43 der Fügestelle 13 aus Figur 2 dargestellt. Wie deutlich zu erkennen ist, benetzt der Schmierstoff 37 gut die Hälfte der Fugenmündung 40, so dass der ausgehärtete Schmierstoff 37 an diesem vorzugsweise axialen Ende 43 der Fügestelle 13 zumindest teilweise die Fügestelle 13 nach außen hin abdichtet. Unterhalb der Schmierstoffschicht ist ansatzweise noch der Stift 25 erkennbar.

In Figur 4 ist ein weiteres Ausführungsbeispiel durch die Fügestelle 13 dargestellt. Beim Hindurchschieben des Stifts 25 in bzw. durch die Hülse 22 hat sich in diesem Fall ein Span 52 gebildet. Dieser Span 52 ist hier von der Hülse 22 abgeschert worden. Der Span 52 wird hier in der Fuge 28 und an der Fugenmündung 40 durch den Schmierstoff 37 gebunden und zwar sowohl durch Adhäsion als auch durch Formschluss. Der Schmierstoff 37 verhindert somit das sich Lösen des Spans 52.

Figur 5 zeigt ein weiteres Ausführungsbeispiel der Fügestelle 13, wobei hier ein Span 52 auf der vom unteren Ende des Stifts 25 abgewandten Seite, d. h. gegen die Bewegungsrichtung des Stifts 25 in der Hülse 22 abgeschert ist. In diesem Fall ist der Span 52 vom Stift 25 abgeschert und wird durch den Schmierstoff 37 sowohl durch Adhäsion als auch durch Formschluss gebunden. Figur 5 zeigt die von der Fugenmündung 40 abgewandte Fugenmündung 49, die auf der von der Fugenmündung 40 abgewandten Seite der Leiterplatte 34 angeordnet ist.

In Figur 6 ist ein Ausführungsbeispiel dargestellt, bei dem auf beiden Seiten der Leiterplatte 34 jeweils ein Span 52 gebildet ist. Auf der unteren Seite der Darstellung der Figur 6 ist ein Span 52 wie in Figur 4 gebildet, auf der oberen Seite der Figur 6 ist ein Span 52 wie in Figur 5 gebildet. Beide Späne 52 werden hier durch Schmierstoff 37 gebunden. In beiden Fällen ist der Span 52 jeweils kohäsiv mit dem ersten Fügepartner 16 bzw. mit dem zweiten Fügepartner 19 verbunden.

In Figur 7 ist ein weiteres Ausführungsbeispiel der Fügestelle 13 gezeigt, bei der sich ein Span 52 bereits von einem der beiden Fügepartner 16 bzw. 19 vollständig abgelöst hat und lediglich durch den ausgehärteten Schmierstoff 37 gebunden ist. Gemäß diesem Ausführungsbeispiel ist der Span 52 formschlüssig in dem Schmierstoff 37 gebunden und gehalten. Gleichzeitig wirken hier auch Adhäsionskräfte.

In Figur 8 ist weiteres Ausführungsbeispiel der Fügestelle 13 dargestellt. In diesem Fall hat sich ein Span 52 von einem der beiden Fügepartner 16 bzw. 19 bereits vollständig gelöst und liegt desweiteren nur an der Außenseite des ausgehärteten Schmierstoffs 37 an. Der Span 52 wird hier nur durch Adhäsionskräfte am Schmierstoff 37 gehalten. Der Span 52 klebt am Schmierstoff 37.

Es können hier somit beispielsweise folgende Fälle auftreten, wonach der zumindest eine Span 52 aus dem gleichen bzw. demselben Material wie der erste Fügepartner 16 (Figur 4) oder aus dem gleichen bzw. selben Material wie der zweite Fügepartner 19 (Figur 6) besteht und somit aus elektrisch leitfähigem Material ist. Der Span 52 kann bei Materialgleichheit von beiden Fügepartnern 16 und 19 auch aus dem gleichen Material wie beide Fügepartner 16 und 19 sein. Dieser Fall ist in Figur 6 dargestellt, wenn beide Fügepartner 16 und 19 aus dem gleichen Material sind.

In Figur 9a ist ein Verfahren zum Schmieren einer Fügestelle 13 eines elektrischen Geräts 10 schematisch dargestellt. Es wird hier ein Verfahren zur Behandlung einer Fügestelle 13 vorgeschlagen, wobei die Fügestelle einen ersten Fügepartner 16, insbesondere eine Hülse 22 und einen zweiten Fügepartner 19, insbesondere einen Stift 25 aufweist. In einem Schritt S_{B} wird einer der Fügepartner 16 und/oder 19 mit einem Schmierstoff 37 benetzt und in einem nachfolgenden Schritt S_{F} der mit Schmierstoff 37 benetzte Fügepartner 16, 19 mit dem anderen Fügepartner 19, 16 gefügt. In einem weiter nachfolgend angeordneten Schritt S_{E} erstarrt der Schmierstoff 37. In einer Variante dieses Verfahrens ist vorgesehen, dass das Erstarren des Schmierstoffs 37 durch Energiezufuhr beschleunigt wird. In diesem Zwischenschritt S_{T, UV} wird die Energie beispielsweise mittels Wärmezufuhr oder durch UV-Strahlung zugeführt, Figur 9b.

Das Benetzen des Stifts 25 mit Schmierstoff 37 wird in einer ersten Variante des Benetzungsschritts S_{B} durch Eintauchen in einen Behälter durchgeführt, der den Schmierstoff 37 zum Inhalt hat.

Alternativ kann auch vorgesehen sein, dass der Schritt Benetzen S_{B} dadurch durchgeführt wird, dass der Stift 25 gezielt lokal mit Schmierstoff 37 bespritzt oder betupft wird.

In Figur 10 ist ein Stift 25 gezeigt, der mit Schmierstoff 37 bespritzt bzw. betupft ist. Wie hier deutlich zu erkennen ist, ist der Schmierstoff 37 von einer derartigen Konsistenz, dass dieser vom Stift 25 nicht abtropft und somit tropffest ist.

In Figur 11 ist dargestellt, wie sowohl die Hülse 22 als auch der Stift 25 jeweils mit Schmierstoff 37 benetzt sind. Dabei ist der Stift 25 an seinem unteren, dem der Hülse 22 zugewandten Ende mit Schmierstoff 37 benetzt. Die Hülse 22 ist wiederum an ihrem, dem Stift 25 zugewandten Ende mit Schmierstoff 37 benetzt. Der Schmierstoff 37 benetzt dabei die Hülse 22 an der Stelle, die später die Fugenmündung 46 sein wird. Hierzu ist der Schmierstoff 37 an die Übergangsstelle zwischen dem Kragen 70 der Hülse 22 und dem ringzylindrischen Abschnitt 73 aufgebracht und benetzt somit die rohrförmige Innenfläche der Hülse 22 und die kragenförmige bzw. ringzylindrische Außenfläche der Hülse 22 bzw. des Kragens 70. Wird nun der Stift 25 in die Hülse 22 eingeführt, so kontaktieren sich die beiden Schichten aus Schmierstoff 37.

Alternativ kann auch vorgesehen sein, dass nur die Hülse 22, wie in Figur 11 dargestellt, mit Schmierstoff benetzt ist und der Stift 25 nicht.

Die Aufbringung des Einpresshilfsstoffs bzw. Schmierstoffs 37 kann über unterschiedliche Prozesse, wie z.B. Dispensen, Stempeln bzw. Betupfen oder Eintauchen erfolgen. Beim eigentlichen Einpressvorgang werden durch die Verwendung des Schmierstoffs 37 die Einpresskräfte aufgrund der Schmierwirkung im Vergleich zum Einpressprozess ohne Schmierstoff 37 deutlich reduziert.

Unter Umständen kann es sich auch anbieten, den Schmierstoff 37 als reines Bindemittel nach dem Stecken aufzutragen, wobei dann allerdings ggf. eine verstärke Spanbildung erfolgt, da der Schmierstoff 37 dann keine Schmierwirkung entfalten kann. Der Schmierstoff 37 wird dann auf die eine oder andere oder beide Fugenmündungen 40 bzw. 49 aufgetragen.

## Patentansprüche

1. Elektrisches Gerät, insbesondere Steuergerät, mit zumindest einer Fügestelle (13) mit einem ersten Fügepartner (16), insbesondere einer Hülse (22), und einem zweiten Fügepartner (19), insbesondere einem Stift (25), wobei die Fügestelle (13) zwischen den beiden Fügepartnern (16,19) eine Fuge (28) aufweist, **dadurch gekennzeichnet, dass** zumindest an der Fuge (28) ein zumindest teilweise erstarrter Schmierstoff (37) vorhanden ist.

2. Elektrisches Gerät nach Anspruch 1, **dadurch gekennzeichnet, dass** der Schmierstoff (37) nicht metallisch ist.

3. Elektrisches Gerät nach Anspruch 1 oder 2, **dadurch gekennzeichnet, dass** der Schmierstoff (37) ein duroplastischer oder elastomerer Kunststoff ist, der durch inneres Vernetzen ausgehärtet ist.

4. Elektrisches Gerät nach einem der vorstehenden Ansprüche, **dadurch gekennzeichnet, dass** der Schmierstoff (37) ein Mehrkomponentenstoff, insbesondere Zwei-Komponentenstoff ist.

5. Elektrisches Gerät nach einem der vorstehenden Ansprüche, **dadurch gekennzeichnet dass** der ausgehärtete Schmierstoff (37) an einem vorzugsweise axialen Ende (43, 46) der Fügestelle (13) zumindest teilweise die Fügestelle (13) nach außen abdichtet.

6. Elektrisches Gerät nach einem der vorstehenden Ansprüche, **dadurch gekennzeichnet, dass** der ausgehärtete bzw. erstarrte Schmierstoff (37) zumindest einen metallischen Span (52) bindet.

7. Elektrisches Gerät nach Anspruch 6, **dadurch gekennzeichnet, dass** der zumindest eine Span (52) aus dem gleichen Material wie der erste Fügepartner (16) und/oder aus dem gleichen Material wie der zweite Fügepartner (19) besteht und aus elektrisch leitfähigem Material ist.

8. Elektrisches Gerät nach Anspruch 6 oder 7, **dadurch gekennzeichnet, dass** der Span (52) kohäsiv mit dem ersten (16) oder zweiten Fügepartner (19) verbunden ist.

9. Elektrisches Gerät nach Anspruch 6 oder 7 **dadurch gekennzeichnet, dass** der Span (52) adhäsiv und/oder formschlüssig mit dem ausgehärteten Schmierstoff (37) verbunden ist.

10. Verfahren zum Schmieren einer Fügestelle (13) eines elektrischen Geräts (10), wobei die Fügestelle (13) einen ersten Fügepartner (16), insbesondere eine Hülse (22), und einen zweiten Fügepartner (19), insbesondere einen Stift (25), aufweist, wobei in einem Schritt S_{B} einer der Fügepartner (16, 19) mit einem Schmierstoff (37) benetzt wird, in einem nachfolgenden Schritt S_{F} der mit Schmierstoff (37) benetzte Fügepartner (16, 19) mit dem anderen Fügepartner (19, 16) gefügt wird und anschließend der Schmierstoff (37) erstarrt.

11. Verfahren nach Anspruch 10 **dadurch gekennzeichnet, dass** das Erstarren des Schmierstoffs (37) durch Energiezufuhr, insbesondere durch Erhöhung der Temperatur T der Fügestelle (13) durch Wärmezufuhr oder UV-Bestrahlung, beschleunigt wird.

12. Verfahren nach Anspruch 10 oder 11, **dadurch gekennzeichnet, dass** der Stift (25) als zweiter Fügepartner (19) in einen Behälter getaucht wird, der den Schmierstoff (37) zum Inhalt hat.

13. Verfahren nach Anspruch 10 oder 11, **dadurch gekennzeichnet, dass** der Stift (25) als zweiter Fügepartner (19) gezielt lokal mit Schmierstoff (37) bespritzt oder betupft wird.

14. Verfahren nach Anspruch 12 oder 13, **dadurch gekennzeichnet, dass** der Schmierstoff (37) vom Stift (25) nicht abtropft und somit tropffest ist.

15. Verfahren nach Anspruch 10 oder 11, **dadurch gekennzeichnet, dass** die Hülse (22) als Fügepartner (16) mit Schmierstoff (37) benetzt wird.

16. Verfahren nach Anspruch 10 bis 15, **dadurch gekennzeichnet, dass** beide Fügepartner (16, 19) vor dem Fügen mit Schmierstoff (37) benetzt werden.

17. Verfahren nach einem der Ansprüche 10 bis 16, **dadurch gekennzeichnet, dass** beim Fügen der beiden Fügepartner (16, 10) aus dem Material eines oder beider Fügepartner (16, 19) ein Span (52) zumindest teilweise abgeschert wird.

18. Verfahren nach Anspruch 17, **dadurch gekennzeichnet, dass** der Span (52) mit dem aushärtenden Schmierstoff (37) adhäsiv oder formschlüssig verbunden wird.

## Claims

1. Electric device, in particular a control device, comprising at least one joint (13) with a first element of the joint (16), in particular a sleeve (22), and a second element of the joint (19), in particular a pin (25), the joint (13) having a gap (28) between the two elements of the joint (16, 19), **characterized in that** an at least partially solidified lubricant (37) is present, at least at the gap (28).

2. Electric device according to Claim 1, **characterized in that** the lubricant (37) is non-metallic.

3. Electric device according to Claim 1 or 2, **characterized in that** the lubricant (37) is a thermosetting or elastomeric plastic, which is cured by internal crosslinkage.

4. Electric device according to one of the preceding claims, **characterized in that** the lubricant (37) is a multi-component substance, in particular a two-component substance.

5. Electric device according to one of the preceding claims, **characterized in that** the cured lubricant (37) at least partially seals the joint (13) with respect to the outside at a preferably axial end (43, 46) of the joint (13).

6. Electric device according to one of the preceding claims, **characterized in that** the cured or solidified lubricant (37) bonds at least one metallic chip (52).

7. Electric device according to Claim 6, **characterized in that** the at least one chip (52) consists of the same material as the first element of the joint (16) and/or of the same material as the second element of the joint (19) and is of electrically conductive material.

8. Electric device according to Claim 6 or 7, **characterized in that** the chip (52) is cohesively joined to the first element of the joint (16) or the second element of the joint (19).

9. Electric device according to Claim 6 or 7, **characterized in that** the chip (52) is adhesively and/or interlockingly joined to the cured lubricant (37).

10. Method for lubricating a joint (13) of an electric device (10), the joint (13) having a first element of the joint (16), in particular a sleeve (22), and a second element of the joint (19), in particular a pin (25), wherein, in a step S_{B}, one of the elements of the joint (16, 19) is wetted with a lubricant (37) and, in a subsequent step S_{F}, the element of the joint (16, 19) that has been wetted with lubricant (37) is joined together with the other element of the joint (19, 16) and then the lubricant (37) solidifies.

11. Method according to Claim 10, **characterized in that** the solidifying of the lubricant (37) is accelerated by supplying energy, in particular by increasing the temperature T of the joint (13) by heat application or UV irradiation.

12. Method according to Claim 10 or 11, **characterized in that** the pin (25), as the second element of the joint (19), is immersed in a container which has the lubricant (37) as its content.

13. Method according to Claim 10 or 11, **characterized in that** the pin (25), as the second element of the joint (19), is specifically sprayed or dabbed locally with lubricant (37).

14. Method according to Claim 12 or 13, **characterized in that** the lubricant (37) does not drip from the pin (25) and is consequently drip-resistant.

15. Method according to Claim 10 or 11, **characterized in that** the sleeve (22), as an element of the joint (16), is wetted with lubricant (37).

16. Method according to Claims 10 to 15, **characterized in that** both elements of the joint (16, 19) are wetted with lubricant (37) before joining.

17. Method according to one of Claims 10 to 16, **characterized in that**, when joining the two elements of the joint (16, 19), a chip (52) is at least partially shear-cut from the material of one or both elements of the joint (16, 19).

18. Method according to Claim 17, **characterized in that** the chip (52) is adhesively or interlockingly joined to the curing lubricant (37).

## Revendications

1. Appareil électrique, en particulier appareil de commande, doté d'au moins un emplacement d'assemblage (13) qui présente un premier partenaire d'assemblage (16), en particulier une douille (22), et un deuxième partenaire d'assemblage (19), en particulier une tige (25), un emplacement d'assemblage (13) présentant une jonction (28) entre les deux partenaires d'assemblage (16, 19),
**caractérisé en ce que**
un lubrifiant (37) au moins partiellement solidifié est prévu au niveau de la jonction (28).

2. Appareil électrique selon la revendication 1, **caractérisé en ce que** le lubrifiant (37) n'est pas métallique.

3. Appareil électrique selon les revendications 1 ou 2, **caractérisé en ce que** le lubrifiant (37) est un matériau synthétique duroplastique ou élastomère qui est durci par réticulation interne.

4. Appareil électrique selon l'une des revendications précédentes, **caractérisé en ce que** le lubrifiant (37) est une substance à plusieurs composants et en particulier une substance à deux composants.

5. Appareil électrique selon l'une des revendications précédentes, **caractérisé en ce que** le lubrifiant durci (37) assure au moins en partie l'étanchéité de l'emplacement d'assemblage (13) vis-à-vis de l'extérieur à une extrémité (43, 46) de préférence axiale de l'emplacement d'assemblage (13).

6. Appareil électrique selon l'une des revendications précédentes, **caractérisé en ce que** le lubrifiant (37) durci ou solidifié relie au moins un copeau métallique (52).

7. Appareil électrique selon la revendication 6, **caractérisé en ce que** le ou les copeaux (52) sont constitués du même matériau que le premier partenaire d'assemblage (16) et/ou du même matériau que le deuxième partenaire d'assemblage (19) et sont constitués d'un matériau électriquement conducteur.

8. Appareil électrique selon les revendications 6 ou 7, **caractérisé en ce que** le copeau (52) est relié par cohésion au premier partenaire d'assemblage (16) ou au deuxième partenaire d'assemblage (19).

9. Appareil électrique selon les revendications 6 ou 7, **caractérisé en ce que** le copeau (52) est relié par adhérence et/ou en correspondance géométrique au lubrifiant (37) durci.

10. Procédé de lubrification d'un emplacement d'assemblage (13) d'un appareil électrique (10), l'emplacement d'assemblage (13) présentant un premier partenaire d'assemblage (16), en particulier une douille (22), et un deuxième partenaire d'assemblage (19), en particulier une tige (25), l'un des partenaires d'assemblage (16, 19) étant mouillé par un lubrifiant (37) dans une étape S_{B}, le partenaire d'assemblage (16, 19) mouillé par le lubrifiant (37) étant assemblé à l'autre partenaire d'assemblage (19, 16) dans une étape ultérieure S_{F}, le lubrifiant (37) étant ensuite durci.

11. Procédé selon la revendication 10, **caractérisé en ce que** la solidification du lubrifiant (37) est accélérée par apport d'énergie, en particulier par augmentation de la température T de l'emplacement d'assemblage (13) par apport de chaleur ou par irradiation aux UV.

12. Procédé selon les revendications 10 ou 11, **caractérisé en ce que** la tige (25) qui constitue le deuxième partenaire d'assemblage (19) est immergée dans un récipient qui contient le lubrifiant (37).

13. Procédé selon les revendications 10 ou 11, **caractérisé en ce que** le lubrifiant (37) est appliqué localement de manière contrôlée sur la tige (25) qui constitue le deuxième partenaire d'assemblage (19), par projection ou au tampon.

14. Procédé selon les revendications 12 ou 13, **caractérisé en ce que** le lubrifiant (37) ne s'égoutte pas de la tige (25) et ne forme donc pas de gouttes.

15. Procédé selon les revendications 10 ou 11, **caractérisé en ce que** la douille (22) qui forme le partenaire d'assemblage (16) est mouillée par le lubrifiant (37).

16. Procédé selon les revendications 10 à 15, **caractérisé en ce que** les deux partenaires d'assemblage (16, 19) sont mouillés par le lubrifiant (37) avant l'assemblage.

17. Procédé selon l'une des revendications 10 à 16, **caractérisé en ce que** lors de l'assemblage des deux partenaires d'assemblage (16, 10), un copeau (52) est au moins partiellement décolleté du matériau d'un ou des deux partenaires d'assemblage (16, 19).

18. Procédé selon la revendication 17, **caractérisé en ce que** le copeau (52) est relié par adhérence ou en correspondance géométrique au lubrifiant (37) durcissant.
